Europäisches Patentamt

European Patent Office

Office européen des brevets

(19)

(11) Numéro de publication: **0 209 928**
**B1**

(12) **FASCICULE DE BREVET EUROPEEN**

(45) Date de publication du fascicule du brevet:
10.01.90

(51) Int. Cl.⁴: **H 03 H 17/06, H 03 D 3/00**

(21) Numéro de dépôt: **86201057.6**

(22) Date de dépôt: **18.06.86**

(54) **Démodulateur de signal numérique modulé en fréquence.**

(30) Priorité: **21.06.85 FR 8509491**

(43) Date de publication de la demande:
**28.01.87 Bulletin 87/5**

(45) Mention de la délivrance du brevet:
**10.01.90 Bulletin 90/2**

(84) Etats contractants désignés:
**DE FR GB SE**

(56) Documents cités:
**GB-A- 2 113 930**
**US-A- 3 956 623**

**ICASSP 81 PROCEEDINGS, Atlanta, Georgia, US, 30,31 mars - 1 avril 1981, vol. 1, pages 220-223, IEEE, New York, US; D. ESTEBAN et al.: "HQMF: Halfband quadrature mirror filters"**
**IEEE TRANSACTIONS ON COMMUNICATION TECHNOLOGY, vol. COM-18, no. 2, avril 1970, pages 110-118, New York, US; J.H. PARK Jr.: "An FM detector for low S/N"**

(73) Titulaire: **Laboratoires d'Electronique et de Physique Appliquée L.E.P., 3, Avenue Descartes BP 15, F-94451 Limeil-Brévannes (FR)**
(84) Etats contractants désignés: **FR**

(73) Titulaire: **N.V. Philips' Gloeilampenfabrieken, Groenewoudseweg 1, NL-5621 BA Eindhoven (NL)**
(84) Etats contractants désignés: **DE GB SE**

(72) Inventeur: **Le Queau, Marcel, Société Civile S.P.I.D. 209 rue de l'Université, F-75007 Paris (FR)**

(74) Mandataire: **Landousy, Christian et al, Société Civile S.P.I.D. 209, Rue de l'Université, F-75007 Paris (FR)**

## Description

La présente invention concerne un démodulateur de signal numérique modulé en fréquence comprenant un filtre numérique de quadrature composé lui-même de n éléments en série retardant chacun le signal d'entrée d'une valeur $T_E = 1/F_E$ où $F_E$ est la fréquence d'échantillonnage, de voies en parallèle le long de la cascade d'éléments de retard et comprenant chacune un multiplicateur par un coefficient déterminé, d'un premier et d'un deuxième sommateur de sorties respectives de ces multiplicateurs, les sorties de ces deux sommateurs constituant les sorties en quadrature dudit filtre dites respectivement de référence et déphasée, et comprenant égalment en sortie du filtre un circuit de calcul de la phase instantanée $\Phi_n$ des échantillons successifs $X_n$. Le brevet US-A-3956623 décrit un dispositif opérant un calcul de ce type.

Le but de l'invention est de proposer un démodulateur à seuil amélioré, avec un filtre numérique de quadrature présentant une réponse amplitude-fréquence identique pour les voies en quadrature et avec en outre un nombre de composants plus faible que les réalisations antérieures, en vue de diminuer le prix de revient.

L'invention concerne à cet effet un démodulateur caractérisé en ce qu'il comprend, en parallèle sur le circuit de calcul de phase instantanée, un circuit d'évaluation du rapport signal/bruit équipé lui-même d'une commande de modification des coefficients du filtre de quadrature lorsque ledit rapport descend au dessous d'un seuil déterminé.

Les particularités de l'invention apparaîtront maintenant de façon plus détaillée dans la description qui suit et dans les dessins annexés donnés à titre d'exemples et dans lesquels:

les figures 1 et 2 montrent des filtres de quadrature de type connu;

la figure 3 montre une structure de filtre de quadrature conforme à l'invention, et la figure 4 un mode de réalisation préférentiel de cette structure de filtre;

la figure 5 montre un exemple de réalisation d'un démodulateur de signal numérique modulé en fréquence incorporant un filtre selon l'invention;

les figures 6 à 8 montrent des variantes perfectionnées de réalisation d'un tel démodulateur.

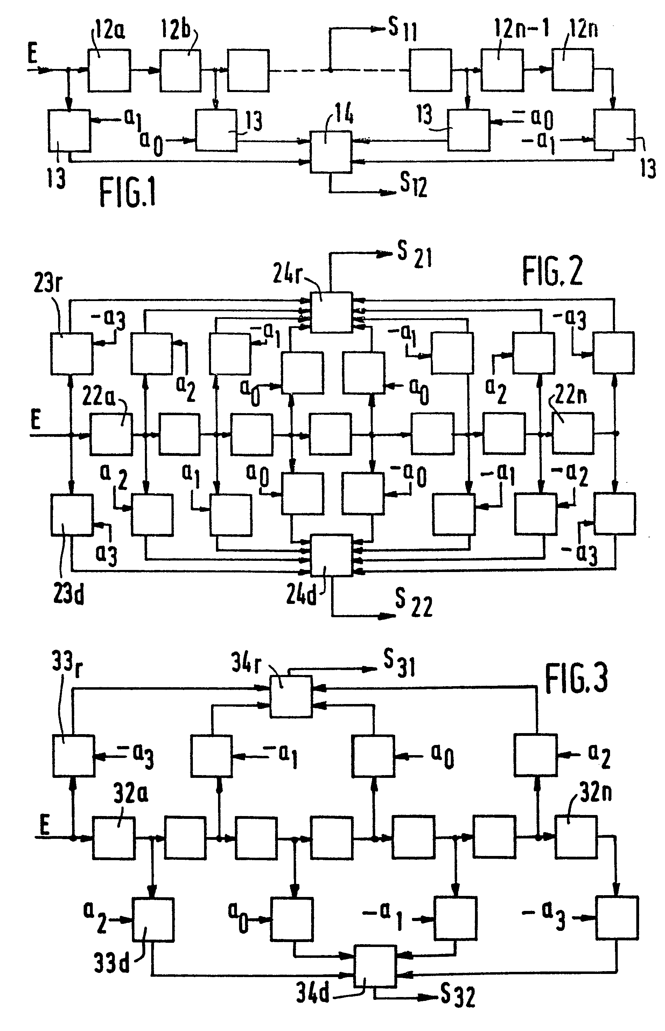

Le filtre numérique de quadrature de structure classique représenté sur la figure 1 comprend une entrée E sur laquelle se présente le signal d'entrée, n éléments 12a à 12n en série (n étant pair dans cet exemple) retardant chacun le signal d'entrée d'une valeur ($T_E = 1/F_E$ où $F_E$ est la période d'échantillonnage, $(n/2) + 1$ voies en parallèle régulièrement espacées le long de la série d'éléments de retard et comprenant chacune un multiplicateur 13 par des coefficients qui sont ici deux à deux égaux en valeur absolue et opposés en signes (respectivement $a_1$, $a_0$, $-a_0$, $-a_1$), et un sommateur 14 des sorties de ces $(n/2) + 1$ voies. Une connexion mise en place entre le $(n/2)$ième et le $(n/2 + 1)$ième élément de retard fournit la sortie de référence $S_{11}$ et la sortie du sommateur 14 constitue la sortie $S_{12}$ déphasée de $\pi/2$ radians par rapport à $S_{11}$ (entre la fréquence 0 et la moitié de la fréquence d'échantillonnage).

La figure 2 montre la généralisation de ce principe à la réalisation d'un filtre déphasant aussi les sorties $S_{11}$ et $S_{22}$ de $+ \pi/2$ radians entre la fréquence 0 et la moitié de la fréquence d'échantillonnage, mais avec une réponse impulsionnelle plus courte. Le filtre comprend à cet effet, dans l'exemple représenté, sept éléments de retard 22a à 22 n en série, $(n + 1)$ premières voies en parallèle conduisant à la sortie de référence $S_{21}$ par l'intermédiaire de $(n + 1)$ multiplicateurs 23r (coefficients: $-a_3$, $a_2$, $-a_1$, $a_0$, $a_0$, $-a_1$, $a_2$, $-a_3$, cette fois-ci deux à deux égaux) et d'un sommateur 24r, et $(n + 1)$ deuxièmes voies en parallèle conduisant à la sortie déphasées $S_{22}$ par l'intermédiaire de $(n + 1)$ multiplicateurs 23d (coefficients: $a_3$, $a_2$, $a_1$, $a_0$, $-a_0$, $-a_1$, $-a_2$, $-a_3$, deux à deux égaux et opposés) et d'un sommateur 24d.

Ce filtre de la figure 2 fait cependant intervenir un nombre important de coefficients et la réponse fréquentielle des deux voies déphasées n'est pas identique dans toute la bande de Nyquist. Le filtre proposé sur la figure 3 pour remédier à ces inconvénients comprend:

– un nombre impair n d'éléments de retard 32a à 32n en série (ici 7);

– un premier jeu de $(n + 1)/2$ voies en parallèle prélevant respectivement le signal d'entrée, et ce signal d'entrée retardé de $2T_E$, $4T_E$, ..., $(n-1)T_E$;

– $(n + 1)/2$ multiplicateurs 33r, par des coefficients respectivement égaux à $-a_3$, $-a_1$, $a_0$, $a_2$ dans l'exemple représenté;

– un sommateur 34r des sorties de ces multiplicateurs, conduisant à la sortie de référence $S_{31}$;

– un deuxième jeu de $(n + 1)/2$ voies en parallèle prélevant respectivement le signal retardé de $T_E$, $3T_E$, $5T_E$, ..., $nT_E$;

– $(n + 1)/2$ multiplicateurs 33d, par des coefficients respectivement égaux à $a_2$, $a_0$, $-a_1$, $-a_3$ dans l'exemple représenté, c'est-à-dire par une suite de coefficients se présentant en ordre inversé de celui de la suite des coefficients affectés aux $(n + 1)/2$ multiplicateurs 33r des premières voies;

– un sommateur 34d des sorties de ces multiplicateurs, qui conduit à la sortie déphasée $S_{32}$ reproduisant la sortie de référence mais avec un déphasage de $+ \pi/2$ radians.

En généralisant l'exemple décrit, si l'on appelle $X_a$, $X_b$, $X_c$, ..., $X_i$, ..., $X_n$, $X_{n+1}$ la suite des $(n + 1)$ échantillons consécutifs du signal d'entrée présents aux bornes des éléments de retard 32a à 32n ($X_a$ étant l'échantillon qui a été retardé n fois, $X_b$ celui qui l'a été $(n-1)$ fois, etc..., et $x_{n+1}$ celui qui se présente à l'entrée du filtre), les deux sommations pondérées effectuées pour obtenir les deux sorties en quadrature sont égales l'une à:

$$C_0 X_a + C_2 X_c + C_4 X_e + ... + C_{(n-1)/2} X_{n-1} \quad (1)$$

et l'autre à:

$$C_{(n-1)/2} X_b + C_{(n-5)/2} X_d + ... + C_2 X_{n-2} + C_0 X_n \quad (2)$$

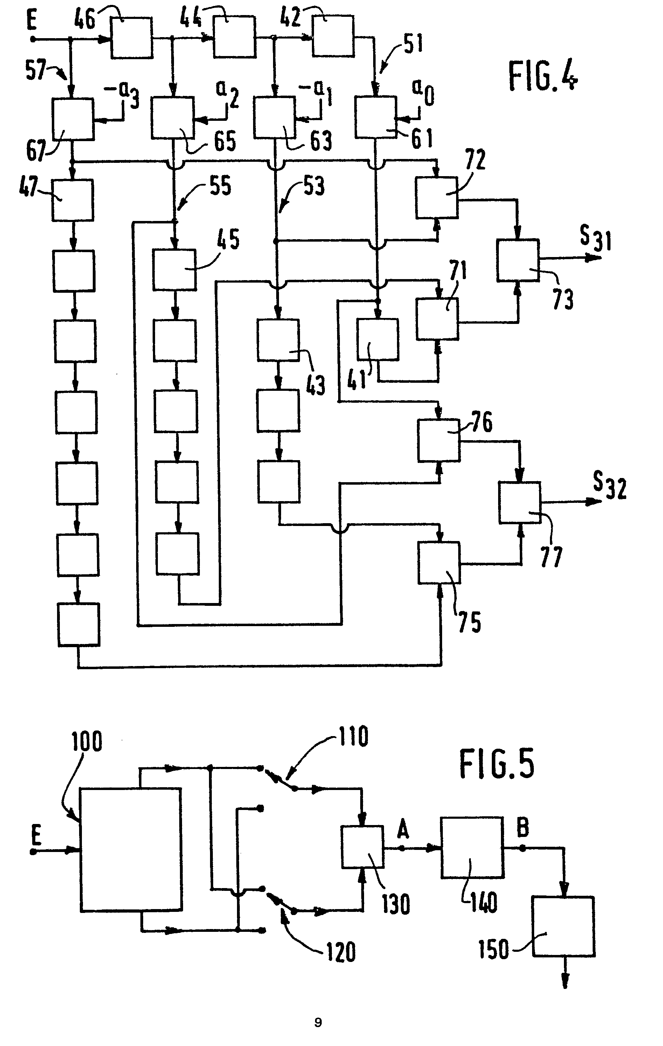

La figure 4 montre une réalisation possible du filtre tel que représenté sur la figure 3 dans son principe. Cette réalisation préférentielle comprend les éléments de retard 46, 44, 42 en série et, reliées aux bornes de ces éléments, quatre voies en parallèle 51, 53, 55, 57 comprenant en série respectivement un premier multiplicateur 61 par le coefficient $a_0$ et un élément de retard 41, un deuxième multiplicateur 63

par le coefficient -$a_1$ et trois éléments à retard 43, un troisième multiplicateur 65 par le coefficient $a_2$ et cinq éléments à retard 45, et un quatrième multiplicateur 67 par le coefficient -$a_3$ et sept éléments à retard 47.

Par ailleurs, les sorties de la voie 51 et de la voie 55 sont reliées aux deux entrées d'un additionneur 71, les sorties des multiplicateurs 63 et 67 aux deux entrées d'un additionneur 72, et les sorties de ces deux additionneurs aux deux entrées d'un additionneur 73 dont la sortie constitue la sortie dite de référence $S_{31}$. De même, les sorties de la voie 53 et de la voie 57 sont reliées aux deux entrées d'un additionneur 75, les sorties des deux multiplicateurs 61 et 65 aux deux entrées d'un additionneur 76, et les sorties de ces deux additionneurs aux deux entrées d'un additionneur 77 dont la sortie constitue la sortie dite déphasée $S_{32}$. Chacun des éléments de retard apporte au signal qui le traverse un retard de la valeur $T_E$ déjà définie. L'examen de la figure 4 ainsi décrite montre qu'en effet le schéma ainsi proposé est équivalent à celui de la figure 3, avec cependant l'avantage de minimiser le nombre des multiplicateurs.

Les avantages du filtre décrit sur les figures 3 et 4 ou, de façon plus générale, de celui correspondant aux deux expressions (1) et (2) ci-dessus sont d'une part l'identité de la réponse amplitude-fréquence pour la partie de filtre délivrant la sortie de référence et pour celle délivrant la sortie déphasée, et d'autre part un sensible raccourcissement de la durée de la réponse impulsionnelle et la réduction du nombre de composants coûtex par rapport au filtre de la figure 2. En outre, un tel filtre permet de calculer simplement l'amplitude d'un signal sinusoïdal échantillonné. En effet, comme les suites d'échantillons $X_n$ et $Y_n$ apparaissant sur les sorties de référence et déphasée respectivement sont déphasées de $\pi/2$, ladite amplitude est égale à $(X_n^2 + Y_n^2)^{1/2}$, l'extraction de racine carrée pouvant être réalisée par exemple par l'intermédiaire d'une mémoire morte.

De même, toujours dans le cas d'un signal sinusoïdal échantillonné, un tel filtre de quadrature permet de déterminer la phase instantanée $\Phi_n$ d'un échantillon $X_n$ en calculant $\Phi_n = \text{Arc tg}\,(X_n/Y_n)$. La division de $X_n$ par $Y_n$ donne la tangente de la phase instantanée qui, par définition, est indépendente de l'amplitude du signal sinusoïdal. On peut donc calculer la phase elle-même à l'aide d'une table contenant la fonction arctangente, comme indiqué sur la figure 5 où l'on peut voir le filtre de quadrature 100 délivrant les échantillons $X_n$ et $Y_n$ sur deux sorties reliées chacune à deux commutateurs 110 et 120, un diviseur 130 (de $X_n$ par $Y_n$ quand $Y_n$ est supérieur ou égal à $X_n$, ou de $Y_n$ par $X_n$ dans le cas contraire, selon la position prise de façon correspondante par les commutateurs 110 et 120), et une mémoire 140 servant de table pour le calcul de la fonction arctangente. La relation entre la tangente et la cotangente permet encore d'utiliser la mémoire 140 même quand $Y_n$ est inférieur à $X_n$. On obient alors la valeur de $\Phi_n$ à $\pm k$ $\pi/2$ près, indétermination qui est levée par un circuit 150 prévu à la suite de la mémoire 140 et destiné à examiner les signes de $X_n$ et $Y_n$.

Si A est la sortie du diviseur 130 et B celle de la mémoire 140, on a A = $|X_n/Y_n|$ si $|Y_n|$ est supérieur ou égal à $X_n$, ou A = $|Y_n/X_n|$ dans le cas contraire. La table qui permet la levée de l'indétermination sur la valeur de $\Phi_n$ est la suivante, avec $S_1$ $S_2$ $S_3$ étant respectivement les signes de $|X_n|$, de $|Y_n|$ et de $|X_n| - |Y_n|$ :

| $S_1$ | $S_2$ | $S_3$ | valeur de $\Phi_n$ |
|---|---|---|---|
| + | + | + | - B + $\pi/2$ |
| + | - | + | + B + $\pi/2$ |
| - | + | + | + B - $\pi/2$ |
| - | - | + | - B - $\pi/2$ |
| + | + | - | + B |
| + | - | - | - B + $\pi$ |
| - | + | - | - B |
| - | - | - | + B - $\pi$ |

Avec le schéma de la figure 5, on obtient ainsi, en sortie du diviseur 130, des résultats ne variant qu'entre + 1 et -1, ce qui évite tout problème lié à des valeurs asymptotiques, et permet de conserver en sortie de la mémoire 140 une précision constante sur la plage -$\pi$ à +$\pi$ radians.

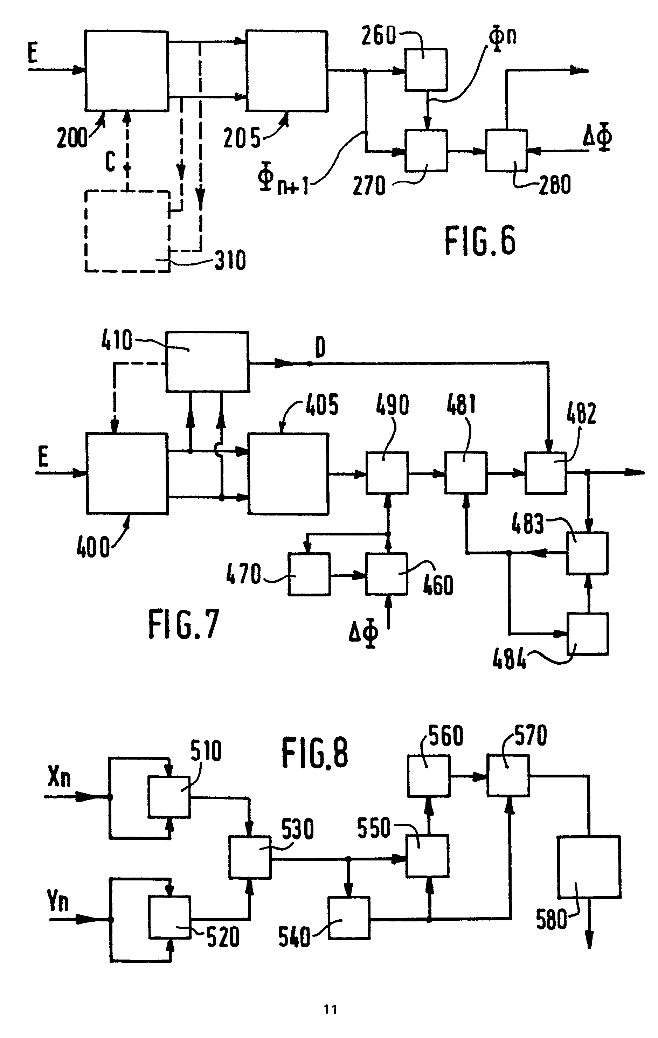

Si $\Phi_n$ et $\Phi_{n+1}$ sont alors les phases instantanées de deux échantillons successifs $X_n$ et $X_{n+1}$ d'un signal numérique modulé en fréquence et si $\triangle\Phi$ est l'incrément de phase de la porteuse du signal modulé entre les deux échantillons, la démodulation numérique dudit signal est réalisable en calculant l'expression $\Phi_{n+1} - \Phi_n - \triangle\Phi$, par exemple selon un schéma de démodulation tel que celui représenté sur la figure 6. Sur cette figure, au signal modulé présent à l'entrée du filtre de quadrature 200 correspondent des paires d'échantillons ($X_n$, $Y_n$), ($X_{n+1}$, $Y_{n+1}$), etc... en sortie de ce filtre. Ces échantillons, par exemple $X_{n+1}$ et $Y_{n+1}$ sur la figure 6, sont envoyés vers un circuit 205 de calcul de phase instantanée comprenant des circuits 210, 220, 230, 240, 250 non représentés car rigoureusement identiques aux éléments 110 à 150 de la figure 5 et fonctionnant de la même manière. Un premier circuit de soustraction 270 reçoit le signal de sortie $\Phi_{n+1}$ de ce circuit 205 sur une première entrée positive et sur une deuxième entrée négative, le signal de sortie $\Phi_n$ déterminé au cours du cycle de calcul précédent du circuit 205, en réponse à la présence de la précédente paire d'échantillons $X_n$, $Y_n$ en sortie du filtre de quadrature 200. Bien entendu, pour que les entrées du circuit 270 soient synchrones, le signal $\Phi_n$ à été retardé d'une période d'échantillonnage $T_E$ dans un élément à retard 260. Un deuxième circuit de soustraction 280 reçoit le signal $\Phi_{n+1} - \Phi_n$ sur son entrée positive et $\triangle\Phi$ sur son entrée négative et fournit le signal de sortie du démodulateur.

Cependant, lorsque le signal modulé en fréquence est accompagné d'un bruit non négligeable par rappot à ce signal, la trajectoire de l'extrémité du vecteur résultant de l'addition du signal modulé et du bruit peut entourer l'origine du repère de cette représentation vectorielle. Il en résulte un saut de phase du vecteur résultant, de $\pm 2\pi$ radians suivant le sens de l'enroulement de la trajectoire. Les démodulateurs de fréquence sont par conséquent caractérisés par un seuil au dessous duquel on observe une dégradation rapide du rapport signal/bruit en sortie quand ce même rapport diminue en entrée.

Certains démodulateurs dits à seuil étendu ou à accroissement de seuil présentent l'avantage d'avoir un seuil inférieur de plusieurs décibels à ceux obtenus avec les autres démodulateurs. L'amélioration du seuil du démodulateur précédemment décrit peut être obtenue, dans le cadre de la présente invention, en changeant les coefficients du filtre de quadrature en fonction du rapport signal/bruit. Comme indiqué en traits interrompus sur la figure 6, il suffit alors de prévoir en sortie du filtre de quadrature 200 et en parallèle sur le circuit 205 de calcul de fréquence instantanée un circuit 310 de calcul ou d'estimation du rapport signal/bruit.

Le circuit 310 délivre un signal C qui permet, en fonction du rapport signal/bruit justement évalué, de changer les coefficients du filtre de quadrature, plus précisément de modifier ces coefficients lorsque le rapport signal/bruit tombe au dessous d'un seuil déterminé, en vue de réduire la bande équivalente de bruit.

L'amélioration du seuil du démodulateur décrit plus haut peut également être obtenue, dans le cadre de l'invention, en proposant le schéma de la figure 7. Le démodulateur représenté sur cette figure comprend comme précédemment un filtre de quadrature 400 et un circuit 405 de calcul de phase instantanée comprenant lui-même, là encore, des circuits 410 à 450 non représentés car indentiques à ceux déjà mentionné et fonctionnant de la même manière. Un accumulateur, constitué par un additionneur 460 et un élément de retard 470 (prélevant la sortie de l'additionneur pour la renvoyer sur une de ses entrées, l'autre recevant l'incrément de phase $\triangle\Phi$), permet de rencontituer à une constante près la phase de la porteuse. La sortie de l'accumulateur est envoyée sur une entrée négative d'un sommateur 490 dont l'autre entrée positive reçoit la sortie du circuit 405 de calcul de phase instantanée et dont la sortie est envoyée vers un filtre récursif.

Ce filtre récursif comprend un sommateur 481 dont une entrée positive reçoit la sortie du sommateur 490 et dont la sortie est fournie à un multiplicateur 482. La sortie de ce multiplicateur, qui constitue la sortie du démodulateur qui est donc porteuse du signal démodulé, est par ailleurs fournie à un accumulateur, constitué de l'additionneur 483 et de l'élément de retard 484 et dont la sortie est renvoyée vers une entrée négative du sommateur 481. L'autre entrée du multiplicateur 482 reçoit le signal de sortie D d'un circuit 410 d'évaluation du rapport signal/bruit prévu, comme précédemment, en parallèle sur les deux entrées du circuit 405 de calcul de phase instantanée.

Le fonctionnement du démodulateur de la figure 7 est le suivant. Comme précédemment, on calcule la phase instantanée $\Phi_n$ d'un échantillon à l'aide du filtre de quadrature et des autres éléments qui le suivent (voir la figure 5). L'accumulateur (483, 484) permet de son côté la reconstitution, à une constante près, de la phase de la porteuse. Le sommateur 481 permet ainsi, à une constante près, de supprimer la porteuse dans la suite des échantillons $\Phi_n$, et le filtre récursif qui le suit se comporte comme une boucle à verrouillage de phase. Cette boucle, dont la sortie fournit le signal démodulé, est verrouillé sur le signal modulé transporté en bande de base.

Les figures 6 (avec le circuit 310) et 7 illustrent donc la mise en oeuvre de deux procédés d'amélioration du seuil qui utilisent l'un et l'autre un rétrécissement de la bande passante pour diminuer le bruit affectant le signal démodulé. Il en résulte certaines distorsions, mais les essais réalisés démontrent nettement que, malgré tout, ces deux procédés améliorent la qualité subjective des images. On peut d'ailleurs combiner ces procédés en prévoyant, sur la figure 7, d'ajouter la connexion de rétroaction mise en place, sur la figure 6, en sortie du circuit d'évaluation du rapport signal/bruit et qui est destinée à la commande de la modification des coefficients du filtre de quadrature lorsque ledit rapport descend au dessous d'un seuil déterminé (cette connexion est en traits interrompus sur la figure 7).

Le circuit 410 d'évaluation du rapport signal/bruit utilise les échantillons X et Y pour déterminer le carré de l'amplitude du signal utile et obtenir une estimation de la puissance de bruit. Une réalisation préférentielle de ce circuit 410 est donnée sur la figure 8. Deux multiplicateurs 510 et 520 et un additionneur 530 permettent, à partir des échantillons $X_n$ et $Y_n$, le calcul du carré du module du signal bruité. Un filtre 540 supprime, dans le signal de sortie de l'additionneur 530, le bruit supposé à moyenne nulle. Un soustracteur 550 relié par ses entrées à l'entrée et à la sortie du filtre 540 calcule alors la valeur absolue de la différence entre le carré du module du signal non bruité (après filtrage), et délivre donc un signal représentatif du carré du bruit. Un filtre passe-bas 560 placé en sortie du soustracteur 550 fournit un signal représentatif de la puissance moyenne du bruit, et un diviseur 570 de la sortie du filtre 540 par ce dernier signal de sortie du filtre 560 délivre un signal exprimant le rapport signal (démodulé)/bruit. Une table 650 identique à celle donnée précédemment (de détermination de la valeur de $\Phi_n$ en fonction de $S_1$, $S_2$, $S_3$) fournit alors les signaux de commande C et/ou D en fonction des seuils choisis.

**Revendications**

1. Démodulateur de signal numérique modulé en fréquence comprenant un filtre numérique de quadrature composé lui-même de n éléments en série retardant chacun le signal d'entrée d'une valeur $T_E = 1/F_E$ où $F_E$ est la fréquence d'échantillonnage, de voies en parallèle le long de la cascade d'éléments de retard et comprenant chacune un multiplicateur par un coefficient déterminé, d'un premier et d'un deuxième sommateur de sorties respectives de ces multiplicateurs, les sorties de ces deux sommateurs constituant les sorties en quadrature dudit filtre dites respectivement de référence et déphasée, et comprenant également en sortie du filtre un circuit de calcul de la phase instantanée $\Phi_n$ des échantillons successifs $X_n$, caractérisé en ce qu'il comprend, en parallèle sur le circuit de calcul de phase instantanée, un circuit d'évaluation du rapport signal/bruit équipé lui-même d'une commande de modification des coefficients du filtre de quadrature lorsque ledit rapport descend au dessous d'un seuil déterminé.

2. Démodulateur selon la revendication 1, caractérisé en ce que la sortie du circuit de calcul de phase instantanée est reliée à l'entrée positive d'un troisième sommateur recevant sur une entrée négative la sortie d'un accumulateur de reconstitution de la phase de la porteuse, la sortie dudit troisième sommateur étant reliée à l'entrée d'un filtre récursif dont la sortie fournit le signal démodulé, en ce que le circuit d'évaluation du rapport signal/bruit comprend des moyens de modification du gain de boucle du filtre récursif lorsque ledit rapport descend au dessous d'un seuil déterminé.

3. Démodulateur selon la revendication 2, caractérisé en ce que le filtre récursif comprend un quatrième sommateur dont une entrée positive reçoit la sortie du troisième sommateur et dont la sortie est fournie à un multiplicateur, la sortie de ce dernier étant elle-même envoyée vers un accumulateur dont la sortie est à son tour renvoyée vers une entrée négative dudit quatrième sommateur, et l'autre entrée du multiplicateur étant reliée à la sortie du circuit d'évaluation du rapport signal/bruit.

4. Démodulateur selon l'une des revendications 2 et 3, caractérisé en ce qu'il comprend, en sortie du circuit d'évaluation du rapport signal/bruit, une connexion de retour destinée à permettre une commande de modification des coefficients du filtre de quadrature lorsque ledit rapport descend au dessous d'un seuil déterminé.

5. Démodulateur selon l'une des revendications 2 à 4, caractérisé en ce que le circuit d'évaluation du rapport signal/bruit comprend un circuit de calcul du carré du module du signal bruité, un filtre d'évalutation carré du module du signal non bruité, un soustracteur de ces carrés délivrant un signal représentatif du carré du bruit, un filtre d'évaluation de la puissance moyenne de ce bruit, un diviseur de la sortie desdits filtres destiné à exprimer le rapport signal/bruit, et un circuit de levée d'indétermination.

**Patentansprüche**

1. Demodulator für frequenzmodulierte digitale Signale mit einem digitalen Quadraturfilter mit n reihengeschalteten Elementen, die je das Eingangssignal um einen Wert $T_E = 1/F_E$ verzögern, wobei $F_E$ die Abtastfrequenz ist, weiterhin mit Kanälen, die parallel zu der Reihenschaltung aus den Verzögerungselementen vorgesehen sind, wobei jeder Kanal einen Multiplizierer zum Multiplizieren mit einem bestimmten Koeffizienten aufweist, sowie mit einem ersten und zweiten Summierer zum Summieren der betreffenden Ausgangssignale der Multiplizierer, wobei die Ausgangssignale der beiden Summierer die Quadraturausgangssignale des genannten Filters bilden, wobei diese Ausgangssignale als Bezugssignale und als phasenverschobene Signale bezeichnet werden, sowie, an dem Ausgang des Filters, mit einer Schaltungsanordnung zum Berechnen der momentanen Phase $\Phi_n$ der aufeinanderfolgenden Abtastwerte $X_n$, dadurch gekennzeichnet, daß der Demodulator parallel zu der Schaltungsanordnung zum Berechnen der momentanen Phase eine Schaltungsanordnung aufweist zum Bewerten des Störabstandes, wobei diese Schaltungsanordnung versehen ist mit einer Steuerschaltung zum Ändern der Koeffizienten des Quadraturfilters, wenn dieser Störabstand einen bestimmten Schwellenwert unterschreitet.

2. Demodulator nach Anspruch 1, dadurch gekennzeichnet, daß der Ausgang der Schaltungsanordnung zum Berechnen der momentanen Phase mit dem positiven Eingang eines dritten Summierers verbunden ist, der an einem negativen Eingang das Ausgangssignal eines Akkumulators zum Rekonstruieren der Phase des Trägers erhält, wobei der Ausgang des genannten dritten Summierers mit dem Eingang eines Rekursivfilters verbunden ist, dessen Ausgang das demodulierte Signal liefert, und daß die Schaltungsanordnung zum Bewerten des Störabstandes Mittel aufweist zum Ändern der Schleifenverstärkung des Rekursivfilters, wenn dieser Störabstand einen bestimmten Schwellenwert unterschreitet.

3. Demodulator nach Anspruch 2, dadurch gekennzeichnet, daß das Rekursivfilter einen vierten Summierer aufweist, von dem ein positiver Eingang das Ausgangssignal des dritten Summierers erhält und dessen Ausgangssignal einem Multiplizierer zugeführt wird, dessen Ausgangssignal einem Akkumulator zugeführt wird, dessen Ausgangssignal wieder einem negativen Eingang des genannten vierten Summierers zugeführt wird, und wobei der andere Eingang des Multiplizierers mit dem Ausgang der Schaltungsanordunung zum Bewerten des Störabstandes verbunden ist.

4. Demodulator nach einem der Ansprüche 2 und 3, dadurch gekennzeichnet, daß er an dem Ausgang der Schaltungsanordnung zum Bewerten des Störabstandes eine Rückkopplung aufweist für einen Befehl zur Änderung der Koeffizienten des Quadraturfilters wenn dieser Störabstand einen bestimmten Schwellenwert unterschreitet.

5. Demodulator nach einem der Ansprüche 2 bis 4, dadurch gekennzeichnet, daß die Schaltungsanordnung zum Bewerten des Störabstandes eine Schaltungsanordnung aufweist zum Berechnen des Quadrats des rauschbehafteten Signalmoduls, ein Filter zum Bewerten des Quadrats des rauschfreien Signalmoduls, eine Subtrahierschaltung für diese Quadrate, was ein Signal ergibt, das für das Quadrat des Rauschwertes repräsentativ ist, weiterhin ein Filter zum Bewerten der mittleren Leistung dieses Rauschwertes, eine Teilerschaltung des Ausgangssignals der genannten Filter zum Ausdrücken des Störabstandes, sowie eine Schaltungsanordnung zum Aufheben einer Unbestimmtheit.

**Claims**

1. A frequency-modulated digital signal demodulator comprising a digital quadrature filter comprising n elements arranged in series each delaying the input signal by a value $T_E = 1/F_E$, where $F_E$ is the sampling frequency, a number of channels arranged in parallel with the cascade arrangement of delay elements, each channel comprising a multiplier for multiplying by a given coefficient, a first and a second summing circuit for summing the respective output signals of said multipliers, the output signals of the said two summing circuits constituting the quadrature output signals of the said filter and being referred to as reference and phase-shifted signals, and comprising at the output of the filter a circuit for calculating the instantaneous phase $\Phi_n$ of successive signal samples $X_n$, charcterized in that it comprises in parallel with the circuit for calculating the instantaneous phase a circuit for evaluating the signal-to-noise ratio which is provided with a control circuit for modifying the coefficients of the quadrature filter when said ratio comes below a given threshold.

2. A demodulator as claimed in Claim 1, characterized in that the output of the circuit for calculating the instantaneous phase is connected to the positive input of a third summing circuit receiving at its negative input the output signal from an accumulator for reconstructing the phase of the carrier, the output of said third summing circuit being connected to the input of a recursive filter whose output supplies the demodulated signal, and in that the circuit for evaluating the signal-to-noise ratio comprises means for modifying the loop gain of the recursive filter when said ratio comes below a given threshold.

3. A demodulator as claimed in Claim 2, characterized in that the recursive filter comprises a fourth summing circuit a positive input of which receives the output signal from the third summing circuit and whose output signal is applied to a multiplier, the output signal of said multiplier being applied to an accumulator whose output signal is in its turn returned to a negative input of the said fourth summing circuit, the other input of the multiplier being connected to the output of the circuit for evaluating the signal-to-noise ratio.

4. A demodulator as claimed in any one of Claims 2 and 3, characterized in that it comprises a feedback coupling arranged at the output of the circuit for evaluating the signal-to-noise ratio and intended for a control of the modification of the quadrature filter coefficients when the said ratio comes below a given threshold.

5. A demodulator as claimed in any one of Claims 2 to 4, characterized in that the circuit for evaluating the signal-to-noise ratio, comprises a circuit for calculating the square value of a signal module, comprising noise, a filter for evaluating the square value of the noiseless signal module, a subtractor for mutually subtracting said square values supplying a signal which is representative of the noise square value, a filter for evaluating the mean power of said noise, a divider at the outputs of said filters for supplying a signal representing the signal-to-noise ratio and a circuit for eliminating indeterminations.

FIG.1

FIG.2

FIG.3

FIG.4

FIG.5

FIG.6

FIG.7

FIG.8